# EUROPEAN PATENT SPECIFICATION

(11) **EP 1 491 962 B1**
(45) Date of publication and mention of the grant of the patent: **13.02.2008**
(21) Application number: 04076828.5
(22) Date of filing: 23.06.2004
(51) Int. Cl.: G03F 7/20

(54) **Lithographic apparatus, device manufacturing method, and device manufactured thereby**
Lithographischer Apparat, Verfahren zur Herstellung einer Vorrichtung und damit erzeugte Vorrichtung
Appareil lithographique, procédé pour la production d'un dispositif et dispositif produit par ce procédé

(30) Priority: 23.06.2003 EP 03076959
(43) Date of publication of application: 29.12.2004
(73) Proprietor: ASML Netherlands B.V., 5504 DR Veldhoven (NL)
(72) Inventor: van Empel, Tjarko Adriaan Rudolf, 5643 SC Eindhoven (NL); Zaal, Koen Jacobus Johannes Maria, 5611 JB Eindhoven (NL); van Meer, Aschwin Lodewijk Hendricus Johannes, 4703 NE Roosendaal (NL); Aantjes, Ton, 5684 EL Best (NL)
(74) Representative: Winckels, Johannes Hubertus F.

(56) References cited:
- EP-A- 1 077 393
- US-A- 5 563 683
- US-A- 5 923 408
- US-A1- 2003 127 605
- US-B1- 6 184 972
- US-B1- 6 257 564
- US-B1- 6 413 701

## Description

The present invention relates to a lithographic projection apparatus comprising: a radiation system for providing a projection beam of radiation; and a substrate holder for supporting a substrate to be placed in a beam path of said projection beam, comprising a plurality of first protrusions the distal ends thereof defining a first contact surface for contacting a substrate, said substrate holder being provided with clamping means for clamping the substrate against the substrate holder.

In order to achieve good image definition and layer overlay the irradiated surface of a substrate should be kept as flat and as stationary as possible during exposure of the substrate. Known lithographic apparatus addresses these demands using the substrate holder hereabove specified, on which a substrate can be placed so that its backside is in contact with the protrusions, all of which lie in a well-defined plane. For example, by connecting aperture(s) in substrate holder to a vacuum generating means, the backside of the substrate can be clamped securely against the protrusions. The use of protrusions in this manner ensures that only a fraction of the area of the backside is actually pressed against a solid surface; in this way, the distorting effect of any particulate contamination on the backside of the wafer is minimized, since such contamination will most probably be situated in the empty spaces between protrusions rather than being pressed against the top surface of a protrusion.

Also, in this way substantially every protrusion contacts the substrate, thus defining one single plane of support that is perfectly level and orientable into required directions. This also poses a problem since there remains a relatively large contact surface of the protrusions physically in contact with the substrate. This may introduce a binding force, in the art known as "sticking", between the top faces of the protrusions of the substrate holder and the backside of substrate. In practice, this means that once a substrate is clamped to the substrate holder and brought into position for a photolithographic irradiation process, releasing the substrate from the substrate holder can take a substantial amount of time causing costly delay in the availability of the machine for a next photolithographic routine. It even may cause jamming of the ejection mechanisms present to release the substrate from the substrate holder. The invention is aimed at minimizing these problems by providing a substrate holder where these sticking forces are not problematic.

In order to achieve this object, the invention provides a lithographic projection apparatus according to the preamble of claim 1, wherein said substrate holder comprises a plurality of second protrusions, the distal ends thereof defining a second contact surface for supporting said substrate, wherein said second protrusions are arranged so that the substrate contacts said first and said second contact surface when the substrate is clamped against the substrate holder en so that said wafer is distanced from said first contact surface when the substrate is not clamped for preventing sticking to the first surface during release of the clamping means.

By such plurality of second protrusions, the sticking forces between the substrate and the substrate holder can be compensated to a desired extent or even be neutralized. Thus, when the clamping means are switched off so that the substrate is no longer clamped to the substrate holder, due to a force provided by elastic deformation of the second protrusions and the wafer that contacts the protrusions, the binding forces between the substrate and substrate holder are reduced.

In a preferred embodiment said plurality of second protrusions is arranged on top of said plurality of first protrusions. Here, preferably, said second contact surface is smaller than said first contact surface. In this respect, it is noted, that where the top surface of the first plurality of protrusions may be substantially flat in terms of surface roughness of a substrate, the top surface of the second plurality of protrusions may be of a less flat nature. By minimizing the contact surface of the second plurality of protrusions, the sticking forces that remain through contact forces between the substrate and the second plurality of protrusions can be minimized.

As a preferred embodiment, each of said first protrusions is provided with a second protrusion, wherein said first and second protrusions are cylindrical. A ratio of diameters of said second protrusions and first protrusions may range between 0.01 and 0.5.

Depending on the ratio of diameters, the distance between said first and second contact surfaces may vary. Preferable ranges are between 6 - 400 nm when the substrate is not clamped against said first contact surface. In this aspect it is noted that with distance, a difference in height between first and second plurality of protrusions is indicated, where, viewed from a flat reference plane, the heights of first and second plurality of protrusions are two discrete values. If the ratio of diameters is large, the distance may be small and vice versa.

A practical embodiment comprises cylindrical first protrusions of 0.5 mm, and second protrusions on top thereof having a diameter of 0.05 mm and defining a distance having one particular value in the range 50-80 nm.

US-A-5923408 discloses a substrate support comprising a plurality of first protrusions the distal ends thereof defining a first contact surface for contacting a substrate, said substrate holder being provided with clamping means for clamping the substrate against the substrate holder. Also a plurality of second protrusions is shown. However, the distal ends of the second protrusions do not define a second contact surface for supporting said substrate, but merely are provided for increasing the rigidity and decreasing the vacuum space.

Embodiments of the invention will now be described, by way of example only, with reference to the accompanying schematic drawings in which corresponding reference symbols indicate corresponding parts, and in which:
Figure 1 depicts a lithographic projection apparatus according to an embodiment of the invention;
Figure 2 depicts a partial schematic side-view of a substrate holder according to the invention;
Figure 3 depicts a partial schematic side-view of part of a substrate holder where a clamping pressure is applied on the substrate, closing the distance formed by the second protrusion;
Figure 4 depicts a partial schematic side-view of a substrate holder wherein a full clamping pressure is applied;
Figure 5 depicts a partial schematic side-view of a substrate holder wherein the clamping pressure is removed; and
Figure 6 depicts a schematic graph illustrating pressure build up in the wafer during application of increasing clamping pressure.

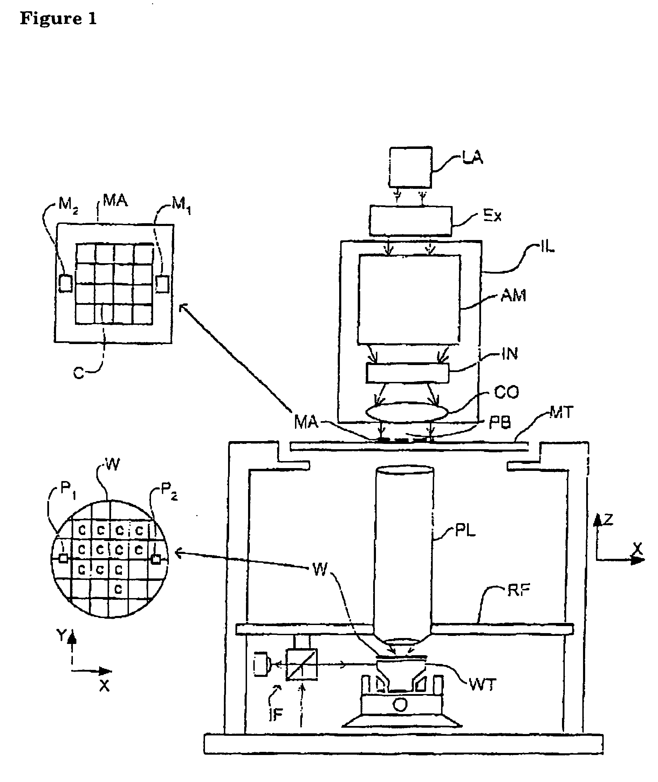

Figure 1 schematically depicts a lithographic projection apparatus according to a particular embodiment of the invention. The apparatus comprises:
- a radiation system Ex, IL, for supplying a projection beam PB of radiation (e.g. light in the deep ultraviolet region). In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (wafer table) WT provided with a holder for holding a substrate W to be irradiated a by patterned beam onto a target portion of the wafer(e.g. a resistcoated silicon wafer), and connected to second positioning means PW for accurately positioning the substrate with respect to item PL; and
- a projection system ("lens") PL for imaging an irradiated portion of the mask MA onto a target portion C (e.g. comprising one or more dies) of the substrate W.

As here depicted, the apparatus is of a reflective type (i.e. has a reflective mask). However, in general, it may also be of a transmissive type, for example (with a transmissive mask). Alternatively, the apparatus may employ another kind of patterning means, such as a programmable mirror array of a type as referred to above.

The source LA (e.g. an excimer laser source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as s-outer and s-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

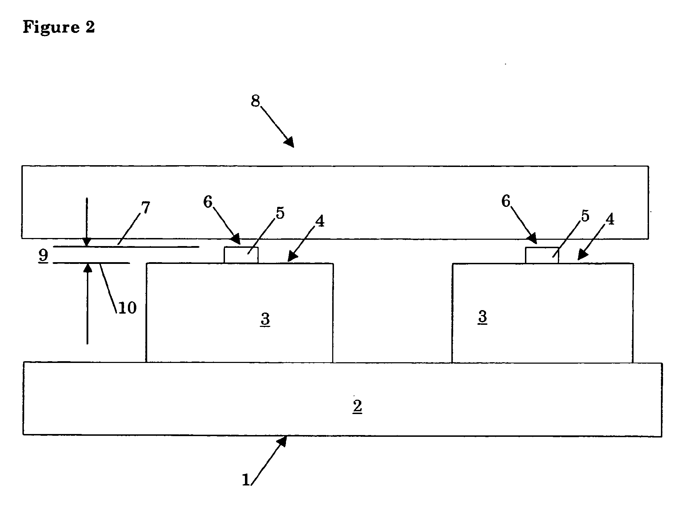

Figure 2 shows a partial schematic side-view of a substrate holder according to the invention. In this partial view, the substrate holder, denoted as wafer table (WT) in Figure 1, is referenced by numeral 1. The substrate holder comprises a substantially flat base plate 2, usually made of SiC, SiSiC, a material known as Zerodur or Cordurite. On this base, first protrusions 3 are formed, also referred to as burls. The burls 3 may be of a cylindrical form, having a surface that is generally flat, in that the planes defined by the top faces 4 of the burls are substantially coincident. On the top faces 4 of the burls 3, second protrusions or so-called micro-burls 5 are formed. In this example, one micro-burl per protrusion is formed on the top face 4 thereof. However, more than one micro-burl may be present. These micro-burls 5 may be generally cylindrically formed and each have a second top face 6 defining a generally flat support surface 7 for a substrate 8 to be supported by the micro-burls 5. In Figure 2 is denoted a gap 9, formed by the height of micro-burls 5. This gap 9 defines a distance between a first contact surface 10, formed by the top faces 4 and the support surface 7, formed by second top faces 6 of the micro-burls 5. In Figure 2, the substrate 8 is shown when the substrate 8 is not clamped to substrate holder 1. In this position, the gap between these contact-surfaces is having one particular value in the range of 50-80 nm. Furthermore, in the example shown in Figure 2, burls 3 are cylindrical of a diameter of 0.5 mm, and the micro-burls 5 on top thereof are cylindrical having a diameter of 0.05 mm.

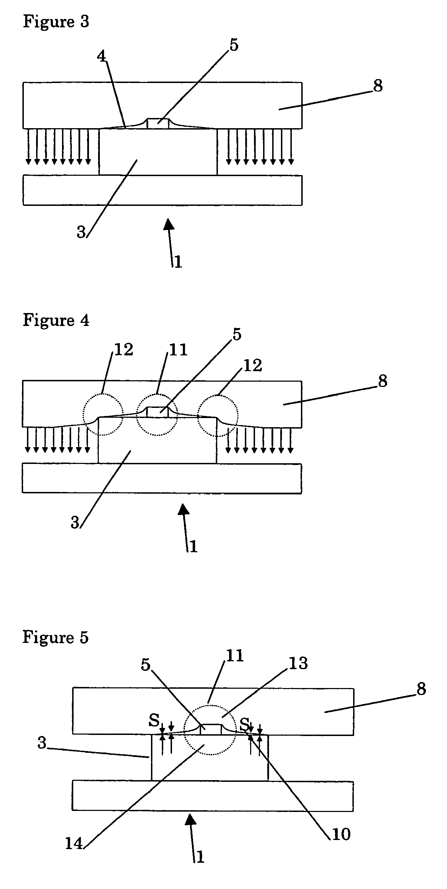

Figures 3- 5 show schematically the deformation process of a substrate that is clamped on the substrate holder 1 according to the invention. In Figure 3, a clamping pressure, such as a vacuum load that ranges from 0 bar (no load applied), to typically 0.5 bar, that is applied on the substrate 8. Initially, while applying increasing pressure, the substrate 8 deforms elastically, so that the micro-burl 5 protrudes into the substrate 8. In this way, the substrate 8 is lowered and contacts the substrate holder 1, and the micro-burl 5 is pushed into the substrate 8. For reasons of simplicity, only the deformation of the substrate 8 is shown in Figure 3. It shall however be understood, that, depending on the relative moduli of deformation, in this process, elastic deformation may occur, both on the face 4 of the burls 3 and on the side of the substrate 8 that contact the (micro-) burls 3(5). Furthermore, Figure 3 illustrates the position where there is applied just enough pressure to close the gap 9 depicted in Figure 1.

In addition, Figure 4 depicts a partial schematic side-view of a substrate holder wherein a full clamping pressure is applied. Here, the elastic deformation of the substrate 8 near the edges 11of the micro-burls 5 is generally unchanged, where the elastic deformation of the substrate 8 near the edges 12 of the burls 3 is increased to a maximum stress value. Here, in an optimal configuration, the stress values near the edges of burls 3 and micro-burls 5 are of a generally same magnitude, which are preferably designed well below a maximum deformation tolerance of the substrate holder 1 and substrate 8.

Figure 5 shows the momentary situation where the clamping pressure is fully released, so that the substrate 8 is no longer pressed against the substrate holder 1. In this moment, sticking forces, schematically illustrated with arrows S, may prevent the substrate 8 from releasing from the substrate holder 1. However, due to the elastic energy, stored in the compressed area 11 in and around the micro-burl 5 (including a compressed zone 13 in the substrate 8, the micro-burl 5 itself and a supporting zone 14 of the micro-burl 5 near the top face 4 of the burls 3), a releasing force is present countering the sticking forces S. The micro-burls 5 are designed such that enough elastic energy is present to release the substrate 8 from the top face 4 of the burls 5 and to separate substrate 8 from the contact surface 10.

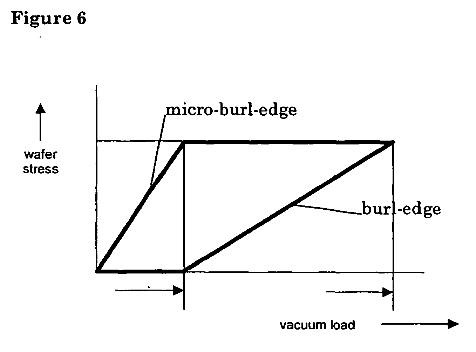

Figure 6 depicts a schematic graph illustrating a modeled stress build up in the substrate during application of increasing clamping pressure. Following the increase of pressure, schematically depicted in Figs 3- 5, in Figure 6, the stress build up is depicted for the compressed zone 11 near the micro-burl 5 (upper line) and for a zone 12 near the edges of the burl 3 referenced in Figure 4 (lower line). Initially, only a top face 6 of micro-burl 5 is in contact with the substrate 8 and stress build up in zone 12 is still absent. In contrast, the stress builds up in zone 13 when contact is made. At that time, stress build up in zone 11 stops. Stress build up in zone 12 continues, and may become equal, smaller or larger than the stress in zone 11.

Here, it is assumed the stress build-up near this zone is inversely proportional to a burl-diameter. Furthermore, it is assumed that the stress and substrate deflection are proportional to the applied load (elastic deformation). In practical experiment, sticky loads of 0.025N per burl were measured. For a wafer that is 0.725 mm thick and a Young's modulus of 110 GPa, for a normal stress level of 0.5 bar vacuum pressure and 0.5 mm burl diameter, a deflection of 80 nm is calculated, and a load of 0.4 N per burl.

From this value, it can be deduced that a burl having a diameter of 0.05 nm, under the same load conditions, would push 800 nm into the substrate, yielding a 10 times higher stress level than the normal stress level. Rescaling the stress level to normal implies that the acceptable load is 0.04 N for a micro-burl of 80 nm height. This micro-burl-maximum load of 0.04 N is well above the sticky force-level of 0.025 N per burl. For a sticky force of 0.025 N this means that the deflection of the substrate is 50 nm - leaving a gap of 30 nm. Under normal load conditions, 10 % of the weight of the load is carried by the micro-burl (0.04N) - leaving 0.36 N for the burl top face.

In the following illustrative examples, minimal, maximal and optimum heights are given for the micro-burls as illustrated with reference to Figure 3 - Figure 6. Herein, Tables 1-3 represent design values for a 0.5 bar clamping pressure, where Tables 4-6 represent design values for a 0.2 bar clamping pressure.

Table 1 below lists the minimum gap as a function of sticking force and relative micro burl diameter for 0.5 Bar clamping pressure. The minimum gap is smaller for larger micro burl diameter, and larger for larger sticking force.

**Table 1**

| Sticking force [N] | Relative micro burl diameter [Dmicroburl/Dburl] | | | | | |
|---|---|---|---|---|---|---|
| | 0.008 | 0.025 | 0.05 | 0.1 | 0.25 | 0.5 |
| 0.0025 | 63 | 20 | 10 | 5 | 2 | 1 |
| 0.010 | 250 | 80 | 40 | 20 | 8 | 4 |
| 0.025 | 625 | 200 | 100 | 50 | 20 | 10 |
| 0.10 | 2500 | 800 | 400 | 200 | 80 | 40 |
| 0.25 | 6250 | 2000 | 1000 | 500 | 200 | 100 |

Table 2 below lists the optimum gap for 0.5 Bar clamping pressure, when the wafer stress caused by the micro burl is equal to the stress caused by the normal burl. For larger sticking forces, larger relative micro burl diameters are required.

**Table 2**

| Sticking force [N] | Relative micro burl diameter [Dmicroburl/Dburl] | | | | | |
|---|---|---|---|---|---|---|
| | 0.012 | 0.025 | 0.05 | 0.1 | 0.25 | 0.5 |
| 0.0025 | | 20 | 40 | 80 | 200 | 400 |
| 0.010 | | | 40 | 80 | 200 | 400 |
| 0.025 | | | | 80 | 200 | 400 |
| 0.10 | | | | | 200 | 400 |
| 0.25 | | | | | | 400 |

Table 3 lists the maximum gap for 0.5 Bar clamping pressure, where wafer stress from the micro burl is ten times larger than the wafer stress from the normal burl. Again, for larger sticking forces larger relative micro burl diameters are required.

**Table 3**

| Sticking force [N] | Relative micro burl diameter [Dmicroburl/Dburl] | | | | | |
|---|---|---|---|---|---|---|
| | 0.012 | 0.025 | 0.05 | 0.1 | 0.25 | 0.5 |
| 0.0025 | 64 | 200 | 400 | 800 | 2000 | 4000 |
| 0.010 | | 200 | 400 | 800 | 2000 | 4000 |
| 0.025 | | 200 | 400 | 800 | 2000 | 4000 |
| 0.10 | | | 400 | 800 | 2000 | 4000 |
| 0.25 | | | | 800 | 2000 | 4000 |

Table 4 - Minimum gap as a function of sticking force and relative micro burl diameter for 0.2 Bar clamping pressure.

**Table 4**

| Sticking force [N] | Relative micro burl diameter [Dmicroburl/Dburl] | | | | | |
|---|---|---|---|---|---|---|
| | 0.008 | 0.025 | 0.05 | 0.1 | 0.25 | 0.5 |
| 0.0025 | 5 | 2 | 1 | 0 | 0 | 0 |
| 0.010 | 20 | 6 | 3 | 2 | 1 | 0 |
| 0.025 | 50 | 16 | 8 | 4 | 2 | 1 |
| 0.10 | 200 | 64 | 32 | 16 | 6 | 3 |
| 0.25 | 500 | 160 | 80 | 40 | 16 | 8 |

Table 5 - Optimum gap as a function of sticking force and relative micro burl diameter for 0.2 Bar clamping pressure.

**Table 5**

| Sticking force [N] | Relative micro burl diameter [Dmicroburl/Dburl] | | | | | |
|---|---|---|---|---|---|---|
| | 0.012 | 0.025 | 0.05 | 0.1 | 0.25 | 0.5 |
| 0.0025 | 6.4 | 20 | 40 | 80 | 200 | 400 |
| 0.010 | | 20 | 40 | 80 | 200 | 400 |
| 0.025 | | 20 | 40 | 80 | 200 | 400 |
| 0.10 | | | 40 | 80 | 200 | 400 |
| 0.25 | | | | 80 | 200 | 400 |

Table 6 - Maximum gap as a function of sticking force and relative micro burl diameter, for a 10 times larger wafer stress from micro burl than from normal burl for 0.2 Bar clamping pressure

**Table 6**

| Sticking force [N] | Relative micro burl diameter [Dmicroburl/Dburl] | | | | | |
|---|---|---|---|---|---|---|
| | 0.012 | 0.025 | 0.05 | 0.1 | 0.25 | 0.5 |
| 0.0025 | 64 | 200 | 400 | 800 | 2000 | 4000 |
| 0.010 | 64 | 200 | 400 | 800 | 2000 | 4000 |
| 0.025 | 64 | 200 | 400 | 800 | 2000 | 4000 |
| | 0.10 | 200 | 400 | 800 | 2000 | 4000 |
| | 0.25 | 200 | 400 | 800 | 2000 | 4000 |

The skilled artisan will appreciate that, in the context of such alternative applications, any use of the terms "reticle" or "wafer" or "substrate" in this text should be considered as being replaced by the more general terms as any article to be placed in the beam path. Such article may encompass patterning means, the patterning means serving to impart the projection beam with a pattern in its cross-section or a substrate to be patterned by a patterned beam onto a target portion of the substrate. In addition the following definitions are given to illustrate general and specific contexts of certain concepts that are used in this text. The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-adressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and
- A programmable LCD array. An example of such a construction is given in United States Patent US 5,229,872, which is incorporated herein by reference. As above, the support structure in this case may be embodied as a frame or table, for example, which may be fixed or movable as required.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

Further, the lithographic apparatus may be of a type having two or more wafer tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid crystal display panels, thin film magnetic heads, etc. In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

Whilst specific embodiments of the invention have been described above, it will be appreciated that the invention may be practiced otherwise than as described. For instance, where the examples describe the substrate holder as a wafer table, for holding a substrate to be patterned by a patterned beam onto a target portion of the substrate, in some embodiments (particularly, in embodiments using a reflective mask), also, the substrate holder may be a support for supporting patterning means, the patterning means serving to impart the projection beam with a pattern in its cross-section. The description is not intended to limit the invention.

## Claims

1. A lithographic projection apparatus comprising:
a radiation system for providing a projection beam of radiation; and
a substrate holder (1) for supporting a substrate (8) to be placed in a beam path of said projection beam, comprising a plurality of first protrusions (3) the distal ends thereof defining a first contact surface (10) for contacting a substrate, said substrate holder (1) being provided with clamping means for clamping the substrate against the substrate holder,
wherein
said substrate holder comprises a plurality of second protrusions (5), the distal ends thereof defining a second contact surface (7) for supporting said substrate, wherein said second protrusions (5) are arranged so that the substrate contacts said first and said second contact surface when the substrate is clamped against the substrate holder (1), **characterized in that** said second protrusions (5) are arranged so that said wafer is distanced from said first contact surface when the substrate is not clamped for preventing sticking to the first surface (10) during release of the clamping means.

2. A lithographic projection apparatus according to claim 1, wherein at least one of said plurality of second protrusions is arranged on top of at least one of said plurality of first protrusions.

3. A lithographic projection apparatus according to claim 1 or 2, wherein said second contact surface is smaller than said first contact surface.

4. A lithographic projection apparatus according to any of the preceding claims, wherein at least a plurality of said first protrusions is provided with one or more second protrusions.

5. A lithographic projection apparatus according to any of the preceding claims, wherein said first and second protrusions are cylindrical.

6. A lithographic projection apparatus according to any of the preceding claims, wherein a ratio of diameters of said second protrusions and first protrusions ranges between 0.01 and 0.5.

7. A lithographic projection apparatus according to any of the preceding claims, wherein a distance between said first and second contact surfaces ranges between 6 - 400 nm when the substrate is not clamped against said first contact surface.

8. A lithographic projection apparatus according to any of the preceding claims, wherein said substrate holder is a support table for holding a substrate to be patterned by a patterned beam onto a target portion of the substrate.

9. A substrate holder (1) for a lithographic projection apparatus according to any of the preceding claims, comprising a plurality of first protrusions (3) the distal ends thereof defining a first contact surface (10) for contacting a substrate; wherein
said substrate holder (1) comprises a plurality of second protrusions (5), the distal ends thereof defining a second contact surface (7) for supporting said substrate (8), wherein said second protrusions (5) are arranged so that the wafer contacts first (10) and second contact surface (7) when the substrate (8) is clamped against the substrate holder (1), **characterized in that** said second protrusions (5) are arranged so that said wafer is distanced from said first contact surface when the substrate is not clamped for preventing sticking to the first surface during release of the clamping means.

## Patentansprüche

1. Lithographische Projektionsvorrichtung, die umfasst:
ein Bestrahlungssystem, um ein Projektionsstrahlungsbündel bereitzustellen; und
einen Substrathalter (1), um ein in einem Weg des Projektionsstrahlenbündels anzuordnendes Substrat (8) zu unterstützen, der mehrere erste Vorsprünge (3) aufweist, deren distale Enden eine erste Kontaktoberfläche (10) für einen Kontakt mit dem Substrat definieren, wobei der Substrathalter (1) mit Klemmmitteln zum Festklemmen des Substrats an dem Substrathalter versehen ist,
wobei
der Substrathalter mehrere zweite Vorsprünge (5) umfasst, deren distale Enden eine zweite Kontaktoberfläche (7) für die Unterstützung des Substrats definieren, wobei die zweiten Vorsprünge (5) so angeordnet sind, dass das Substrat mit der ersten und mit der zweiten Kontaktoberfläche in Kontakt ist, wenn das Substrat an dem Substrathalter (1) festgeklemmt ist, **dadurch gekennzeichnet, dass** die zweiten Vorsprünge (5) so angeordnet sind, dass der Wafer in einem Abstand von der ersten Kontaktoberfläche gehalten wird, wenn das Substrat nicht festgeklemmt ist, um ein Anhaften an der ersten Oberfläche (10) während des Lösens der Klemmmittel zu verhindern.

2. Lithographische Projektionsvorrichtung nach Anspruch 1, wobei wenigstens einer der mehreren zweiten Vorsprünge an der Oberseite wenigstens eines der mehreren ersten Vorsprünge angeordnet ist.

3. Lithographische Projektionsvorrichtung nach Anspruch 1 oder 2, wobei die zweite Kontaktoberfläche kleiner als die erste Kontaktoberfläche ist.

4. Lithographische Projektionsvorrichtung nach einem der vorhergehenden Ansprüche, wobei wenigstens eine Mehrzahl der ersten Vorsprünge mit einem oder mit mehreren zweiten Vorsprüngen versehen ist.

5. Lithographische Projektionsvorrichtung nach einem der vorhergehenden Ansprüche, wobei die ersten und die zweiten Vorsprünge zylindrisch sind.

6. Lithographische Projektionsvorrichtung nach einem der vorhergehenden Ansprüche, wobei ein Verhältnis der Durchmesser der zweiten Vorsprünge und der ersten Vorsprünge im Bereich von 0,01 bis 0,5 liegt.

7. Lithographische Projektionsvorrichtung nach einem der vorhergehenden Ansprüche, wobei ein Abstand zwischen den ersten und den zweiten Kontaktoberflächen im Bereich von 6-400 nm liegt, wenn das Substrat nicht an der ersten Kontaktoberfläche festgeklemmt ist.

8. Lithographische Projektionsvorrichtung nach einem der vorhergehenden Ansprüche, wobei der Substrathalter ein Tragetisch zum Halten eines Substrats ist, das durch ein Strukturierungsstrahlungsbündel auf einem Zielabschnitt des Substrats strukturiert werden soll.

9. Substrathalter (1) für eine lithographische Projektionsvorrichtung nach einem der vorhergehenden Ansprüche, der mehrere erste Vorsprünge (3) umfasst, deren distale Enden eine erste Kontaktoberfläche (10) für einen Kontakt mit einem Substrat definieren; wobei
der Substrathalter (1) mehrere zweite Vorsprünge (5) umfasst, deren distale Enden eine zweite Kontaktoberfläche (7) für die Unterstützung des Substrats (8) definieren, wobei die zweiten Vorsprünge (5) so angeordnet sind, dass der Wafer mit der ersten Kontaktoberfläche (10) und mit der zweiten Kontaktoberfläche (7) in Kontakt ist, wenn das Substrat (8) an dem Substrathalter (1) festgeklemmt ist, **dadurch gekennzeichnet, dass** die zweiten Vorsprünge (5) so angeordnet sind, dass der Wafer in einem Abstand von der ersten Kontaktoberfläche gehalten wird, wenn das Substrat nicht festgeklemmt ist, um ein Anhaften der ersten Oberfläche während des Lösens der Klemmmittel zu verhindern.

## Revendications

1. Appareil de projection lithographique, comprenant :
un système de rayonnement pour fournir un faisceau de rayonnement projeté ; et,
un support de substrat (1) pour supporter un substrat (8) devant être placé sur un chemin de faisceau dudit faisceau projeté, comprenant une pluralité de premières protubérances (3) dont les extrémités distales définissent une première surface de contact (10) pour venir en contact avec un substrat, ledit support de substrat (1) étant pourvu de moyens de serrage pour serrer le substrat contre le support de substrat,
dans lequel :
ledit support de substrat comprend une pluralité de deuxièmes protubérances (5), dont les extrémités distales définissent une deuxième surface de contact (7) pour supporter ledit substrat, dans lequel lesdites deuxièmes protubérances (5) sont agencées de telle sorte que le substrat vienne en contact avec ladite première et ladite deuxième surfaces de contact quand le substrat est serré contre le support de substrat (1), **caractérisé en ce que** lesdites deuxièmes protubérances (5) sont agencées de telle sorte que ladite tranche se trouve à une certaine distance par rapport à ladite première surface de contact quand le substrat n'est pas serré de façon à prévenir toute adhésion sur la première surface (10) au cours du desserrage des moyens de serrage.

2. Appareil de projection lithographique selon la revendication 1, dans lequel au moins une de ladite pluralité de deuxièmes protubérances est disposée en dessus d'au moins une de ladite pluralité de premières protubérances.

3. Appareil de projection lithographique selon la revendication 1 ou 2, dans lequel ladite deuxième surface de contact est plus petite que ladite première surface de contact.

4. Appareil de projection lithographique selon l'une quelconque des revendications précédentes, dans lequel au moins une pluralité desdites premières protubérances comportent une ou plusieurs deuxièmes protubérances.

5. Appareil de projection lithographique selon l'une quelconque des revendications précédentes, dans lequel lesdites premières et lesdites deuxièmes protubérances sont cylindriques.

6. Appareil de projection lithographique selon l'une quelconque des revendications précédentes, dans lequel un rapport entre les diamètres desdites deuxièmes protubérances et desdites premières protubérances est compris entre 0,01 et 0,5.

7. Appareil de projection lithographique selon l'une quelconque des revendications précédentes, dans lequel une distance entre lesdites première et deuxième surfaces de contact est comprise entre 6 nm et 400 nm quand le substrat n'est pas serré contre ladite première surface de contact.

8. Appareil de projection lithographique selon l'une quelconque des revendications précédentes, dans lequel ledit support de substrat est un plateau de support pour maintenir un substrat destiné à être façonné par un faisceau de façonnage sur une portion cible du substrat.

9. Support de substrat (1) pour un appareil de projection lithographique selon l'une quelconque des revendications précédentes, comprenant une pluralité de premières protubérances (3) dont les extrémités distales définissent une première surface de contact (10) pour venir en contact avec un substrat ; dans lequel :
ledit support de substrat (1) comprend une pluralité de deuxièmes protubérances (5), dont les extrémités distales définissent une deuxième surface de contact (7) pour supporter ledit substrat (8), dans lequel lesdites deuxièmes protubérances (5) sont agencées de telle sorte que la tranche vient en contact avec une première (10) et une deuxième (7) surfaces de contact quand le substrat (8) est serré contre le support de substrat (1), **caractérisé en ce que** lesdites deuxièmes protubérances (5) sont agencées de telle sorte que ladite tranche se trouve à une certaine distance par rapport à ladite première surface de contact quand le substrat n'est pas serré de façon à prévenir toute adhésion sur la première surface au cours du desserrage des moyens de serrage.
